# EUROPEAN PATENT SPECIFICATION

(11) **EP 3 171 399 B1**
(45) Date of publication and mention of the grant of the patent: **03.06.2020**
(21) Application number: 15195145.6
(22) Date of filing: 18.11.2015
(51) Int. Cl.: H01L 21/683, H01L 21/768, H01L 21/78, H01L 23/48, H01L 25/065, H01L 21/98

(54) **METHOD FOR SINGULATING A STACK OF SEMICONDUCTOR WAFERS**
VERFAHREN ZUR VEREINZELUNG EINES STAPELS VON HALBLEITERWAFERN
PROCÉDÉ D'INDIVIDUALISATION D'UN EMPILEMENT DE TRANCHES DE SEMI-CONDUCTEUR

(43) Date of publication of application: 24.05.2017
(73) Proprietor: IMEC VZW, 3001 Leuven (BE)
(72) Inventor: De Vos, Joeri, 3001 Leuven (BE); Beyne, Eric, 3001 Leuven (BE)
(74) Representative: Patent Department IMEC

(56) References cited:
- US-A1- 2002 013 061
- US-A1- 2004 087 059
- US-A1- 2005 176 166
- US-A1- 2006 043 533
- US-A1- 2015 079 761
- US-A1- 2015 279 739
- US-B1- 7 871 857

## Description

### Field of the Invention

The present invention is related to singulation methods for the production of 3D integrated circuit chips.

### State of the art

In the fabrication of 3D-integrated ICs produced on wafer level, the dies in a 3D-stack are assembled by bonding complete semiconductor wafers, each wafer comprising a plurality of dies on its surface to form a wafer stack, followed by the singulation of the stack into separate 3D chips. Singulating a wafer stack is particularly challenging using the standard dicing methods such as laser dicing or blade dicing. One particular problem is the fact that the low-k and ultra-low k dielectrics applied in present day integrated circuits are increasingly porous and fragile. In addition, the standard dicing methods require a relatively broad dicing street, i.e. the area between the active area of neighbouring dies needs to be large in order to avoid damage to the dies. As a consequence, a large surface area of the wafers is lost.

Singulation by plasma etching has been described for singulation of single wafers. In a stack of wafers however, this would require multiple etch recipes to be applied sequentially in separate etching tools, which would result in a complex process with low throughput. Applying a single etching tool is equally problematic, in terms of finding a tool and/or etch recipe that is suitable for etching the variety of materials encountered in a wafer stack.

US 7871857 B1 discloses bonding a plurality of wafers together, each wafer comprising dicing streets, wherein the dicing streets are aligned during bonding. To singulate wafer stacks, the substrates are planarised.

US 2015/279739 A1 discloses aligned dicing streets in a wafer front- and backside, and singulating a wafer by etching through the aligned streets using a mask.

### Summary of the invention

The invention is related to a method for singulating a semiconductor wafer stack as described in the appended claims. According to the method of the invention, a plurality of wafers, each comprising a plurality of integrated circuit dies, are bonded to form a stack of wafers. In this stack, the dies are bonded together by direct bonding techniques as known in the art. According to the invention, prior to each bonding step, singulation streets are produced along the circumference of two dies that are to bonded, to the extent that in areas surrounding central active portions of the dies, all materials are removed from the two surfaces that are to be bonded except the material of the semiconductor substrate. This is preferably done by a litho and etch step, etching down through the materials until reaching the substrate portion. Singulation streets on directly bonded surfaces are mutually aligned in the bonding steps, and all singulation streets in the stack are equally aligned to each other. An additional singulation street, aligned with the earlier produced singulation streets, is produced on the top layer of the stack, after production of contact structures such as bumps or pillars. Separation of a stack of dies from the wafer stack is achievable by a single etch step, removing the material of the substrates of the stack, in the area corresponding to the aligned singulation streets.

The invention is set out in the appended claims 1-15. According to an embodiment, the dies form an array of adjacent polygon-shaped areas on the wafers, and at least part of the sides of the intermediate and upper singulation streets overlap the boundaries between two adjacent dies. For example, the sides of the singulation streets overlap the boundaries except in the corner areas between two sides of the boundaries, where the singulation streets are rounded.

### Brief description of the figures

Figure 1 illustrates a portion of a semiconductor wafer surface, comprising an array of integrated circuit dies.
Figure 2 shows a cross section of two dies produced on two wafers, which are to be bonded by direct bonding.
Figure 3 shows the production of intermediate singulation streets on the two dies, prior to bonding.
Figures 4 and 5 illustrate respectively the bonding process and the thinning of the upper wafer in a two-wafer bonded wafer assembly.
Figure 6 illustrates the production of through-semiconductor vias (TSVs) and contact structures to complete the wafer stack.
Figures 7a and 7b show the production of an upper singulation street on the top layer of the stack.
Figures 8 to 11 illustrates the final separation of a die stack from the wafer stack according to a first embodiment.
Figures 12 to 14 illustrate the separation of a die stack from the wafer stack according to a second embodiment.
Figure 15 illustrates the method of the invention applied to a stack of more than two wafers.
Figure 16a illustrates the position of the singulation streets applied in the method of the invention, as seen on a plurality of dies. Figure 16b illustrates the position of the singulation streets in an embodiment wherein singulation streets overlap the boundaries between neighbouring dies.

### Detailed description of the invention

In the enclosed figures, a method is illustrated according to an embodiment of the invention, for producing a stack of two directly bonded wafers, and dicing the stack to form separate 3D dies. The method is not limited to this number of stacked wafers and is applicable also to stacks of more than 2 wafers. Unless stated otherwise, the invention is not limited to any details shown in or described with respect to the drawings. The drawings are meant to illustrate the method of the invention. Components and layers shown in the drawings are not drawn to scale.

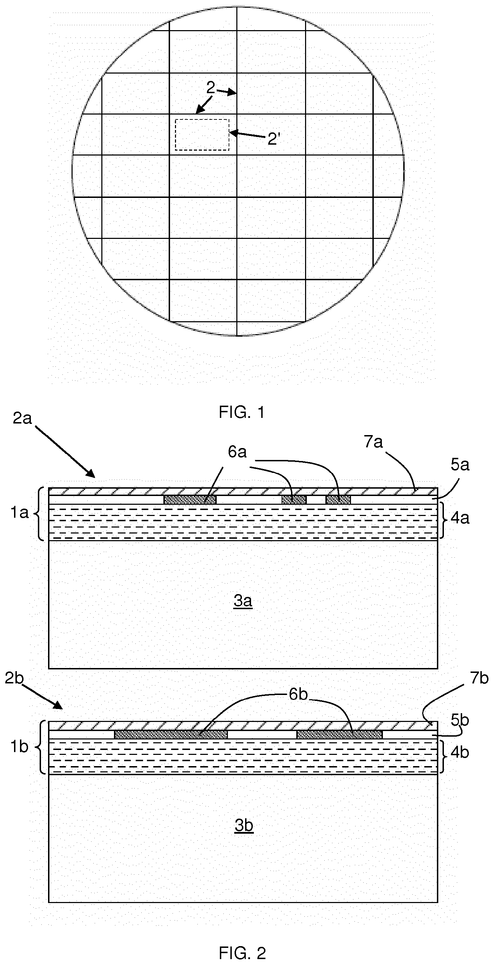

Figure 1 shows an image of (part of) an array of integrated circuit dies 2, as it may be present on the surface of a wafer at the end of a production process for fabricating dies of a particular type on a semiconductor substrate.

Figure 2 shows a cross-section of two dies 2a and 2b which are to be bonded by direct bonding of two such wafers. So it is clear that the dies shown in Figure 2 are each part of a larger wafer and that only one die of each wafer is shown. Each wafer comprises a semiconductor substrate and a 'functional layer' formed thereon, in direct contact with the substrate. The functional layer is in direct contact with the substrate and may comprise a variety of layers. In the specific case shown in Figure 2, the functional layer is a stack of layers comprising active components and interconnects for each die on the wafer. Each die 2a/2b thus comprises a semiconductor substrate portion 3a/3b, and what is defined in the context of the present specification as a 'functional layer portion 1a/1b'. Each die furthermore comprises a central portion 2' (see Figure 1), which comprises at least the 'active' part of the die, i.e. the portion comprising all active components and circuitry of the die. In the embodiment shown, the functional layer portions 1a and 1b of both dies 2a and 2b comprise a Front-End-Of-Line (FEOL) portion produced on the semiconductor substrate portion 3a/3b and a Back-End-Of-Line (BEOL) portion on the FEOL portion. The terms FEOL and BEOL are known in the art of semiconductor processing. FEOL refers to the part comprising active components such as transistors or diodes, and BEOL refers to the part comprising a metallization stack, i.e. a stack of dielectric layers with metal lines and via connections embedded therein and obtainable by single or double damascene techniques. The FEOL and BEOL portions are schematically indicated, without a visible distinction being made between FEOL and BEOL, by reference numerals 4a/4b. The functional layer portions 1a/1b furthermore comprise redistribution layers 5a/5b which are further dielectric layers on top of the BEOL portion with metal contacts 6a/6b embedded therein, the contacts 6a/6b being configured to connect the BEOL metallization stack to external contact terminals. On top of the redistribution layers 5a/5b, the functional layer portions 1a/1b include dielectric bonding layers 7a/7b suitable for direct bonding. The term 'direct bonding' within the present context indicates bonding processes wherein dielectric planar bonding layers are brought into mutual contact and wherein the interaction between the bonding layers establishes the bond, possibly after an annealing step, and/or after a thermocompression step. Direct bonding layers may for example be silicon oxide layers, silicon carbon nitride layers (SiCN) or photopatternable polymer glue layers (see further) or the direct bonding layers may comprise a stack of different materials. The bonding layers may be blanket dielectric layers or they could comprise metal areas and dielectric areas, wherein metal is bonded to metal and dielectric to dielectric. In this case the bonding technique still falls under the denomination 'direct bonding', but it is also known as 'hybrid bonding'. The metal areas could be in the same plane as the bonding layers or they may represent a given topology with respect to the bonding layers, e.g. pillars on one surface contacting recessed areas on the other surface by insertion bonding. In the latter case, the pillars are usually surrounded by a an underfill layer which may be a polymer glue layer as referred to above. The underfill layer thus falls under the definition of a direct bonding layer in the context of this description.

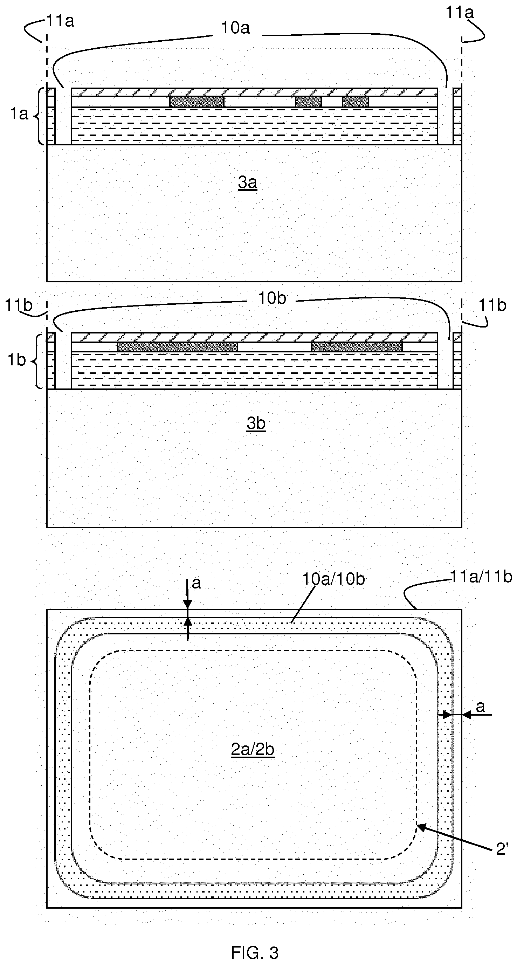

Before performing the bonding step, singulation streets 10a/10b are produced along the circumference of each of the dies 2a/2b, see Figure 3. The singulation streets circumvent the active central portion 2' of the dies. The singulation streets may be produced inside the outer boundaries 11a/11b of the dies, for example (and except in the corner areas) at a constant distance a from the outer boundaries of the dies, as illustrated in the top view of either of the dies 2a/2b in Figure 3. In the corners, the streets are preferably rounded as shown in the drawings. The singulation streets do not necessarily have to be located completely within the boundaries 11a/11b of the dies (distance a > 0). In a preferred embodiment that maximizes the usage of the wafer surface, the streets may actually be overlapping these boundaries, with the sides of the streets being common to two adjacent dies. This embodiment will be illustrated later in this description, but for the purpose of explaining the method, the embodiment with separate singulation streets 10a/10b for each die is used. The singulation streets are preferably produced by lithography and anisotropic etching through the materials of the functional portions 1a/1b, i.e. through the FEOL/BEOL portions 4a/4b, the redistribution layers 5a/5b, and the bonding layers 7a/7b, until reaching the material of the substrate portions 3a/3b. The design of the dies is adapted for this purpose, in the sense that no metal is present in the areas corresponding to the singulation streets, as these metals would be difficult to remove by the same etch recipe as the dielectric portions of the singulation street. Each of the two singulation streets 10a/10b is therefore produced in a single etching step. This may for example be achieved by a C₄F₈ based plasma etch using Ar and/or O₂ as additives. Conditions under which to apply this type of etch chemistry are known in the art and not described here in detail. The singulation streets are preferably as narrow as possible, for example they may be about 10 micrometer wide, for a substrate 3a/3b of 100 micrometer thick and a total dielectric thickness of the functional layer 1a/1b of 3.5 micrometer. The singulation streets 10a and 10b have the same shape (as seen in the plane of the surface of the dies) so that they can be aligned to each other in such a manner that a single open area is formed.

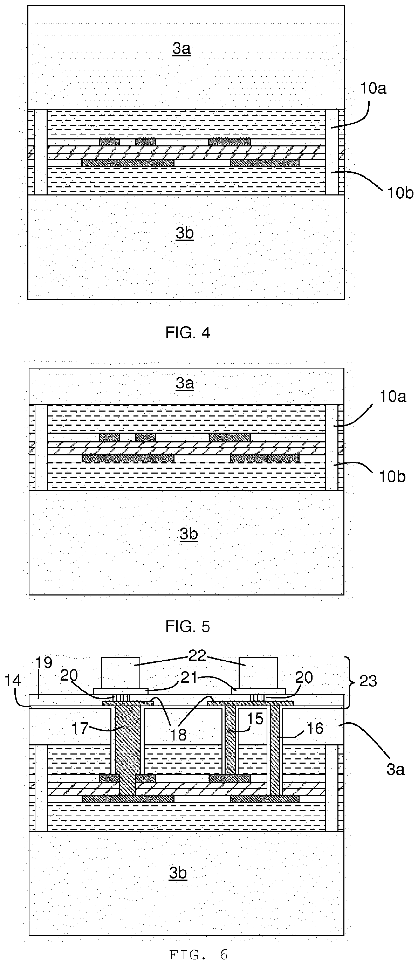

Then the wafers are bonded by direct bonding. The top wafer 2a is flipped and aligned to the lower wafer 2b, as illustrated in Figure 4. Careful positioning of the wafers is required so that the singulation streets 10a/10b are substantially aligned. As illustrated in Figure 4, the bonding layers 7a/7b are brought into mutual contact. An annealing step is preferably performed in order to establish a strong bond. Details of this direct bonding step are not given here as these techniques are known as such by the skilled person.

When the bond is formed, the result is an assembly of the two wafers as shown in Figure 4, with the aligned singulation streets 10a and 10b forming one open area along the circumference of the stacked dies 2a and 2b. The singulation streets 10a/10b produced prior to the bonding step are referred to as the intermediate singulation streets produced in the method of the invention as described in the claims. When the stack of dies comprises more than two dies, the intermediate singulation streets thus form a stack of aligned singulation streets, each pair of singulation streets produced in directly bonded surfaces forming a single open area as referred to above.

Returning to the embodiment shown in the figures, the assembly obtained after the direct bonding step is subsequently thinned, thereby removing a portion of the top wafer's semiconductor substrate 3a, typically reducing this substrate to a thickness of less than 50 micrometer. The result of this thinning step is illustrated in Figure 5.

This is followed by the formation of Through Semiconductor Via (TSV) connections 15/16/17, as illustrated in Figure 6. The TSVs are formed by methods known per se in the art. Preferably this involves a litho+etch step to form openings through the upper substrate 3a, and down to the contacts 6a and/or 6b. A dielectric isolation layer also known as a liner 14 is conformally deposited on the sidewalls of the openings and the top surface of the upper substrate 3a, after which a seed layer (and if required a barrier layer) is deposited in the openings and the openings are filled by electroplating of a suitable metal, preferably copper, followed by a planarizing step such as a Chemical Mechanical Polishing step (CMP). The TSVs interconnect the metal contacts 6a/6b of the two dies 2a/2b of the stack. In the exemplary case shown in the drawings, this is done by a pair of TSVs 15/16 and by a single TSV 17 having two different diameters. The wafer stack is finished by forming interconnects (obtainable by damascene processing) on top of the TSVs, the interconnects 18 being embedded in a dielectric layer 19 that further comprises connections 20 towards contact pads 21. Contact structures 22 such as bumps or pillars are finally produced on the contact pads 21. The layer 23 comprising the interconnects 18, dielectric layers 14/19, connections 20, contact pads 21 and bumps or pillars 22 is an embodiment of the 'top layer' cited in the appended claims. The processes for producing such a top layer 23 are known in the art and not described here in detail. The dielectric layer 14/19 is merely an example of a dielectric portion of the 'top layer', which need not necessarily comprise the liner 14 (e.g. the liner may be first removed from the upper surface before depositing the dielectric layer or layers of the top layer 23).

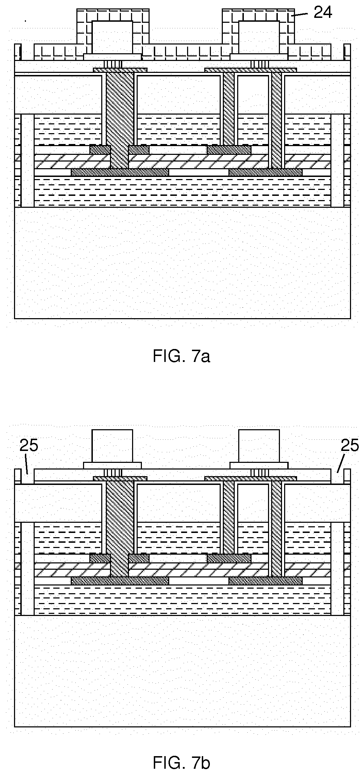

According to the invention, an upper singulation street 25 is now produced in the dielectric layers 14/19 in the top layer 23 of the wafer stack, see Figures 7a and 7b. This upper singulation street 25 has the same shape and preferably the same width as the first and second singulation streets 10a/10b produced prior to bonding. The upper singulation street 25 is aligned with the previously produced singulation streets 10a/10b. It is preferably produced by a litho+ anisotropic etch step until reaching the material of the thinned upper substrate 3a. The upper singulation street 25 is produced after completion of the contact bumps or pillars 22. This may be achieved by producing a lithography mask 24, preferably a resist mask, on top of the bumps 22, as illustrated in Figure 7a. After the etching step, the litho-mask may be stripped as shown in Figure 7b. Alternatively, the mask may remain and be stripped later in the process, as will be explained at a later point in this description.

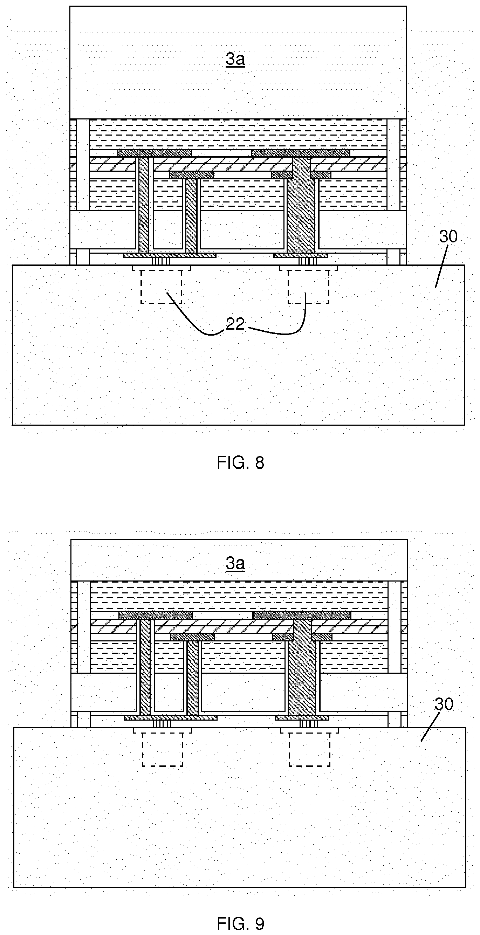

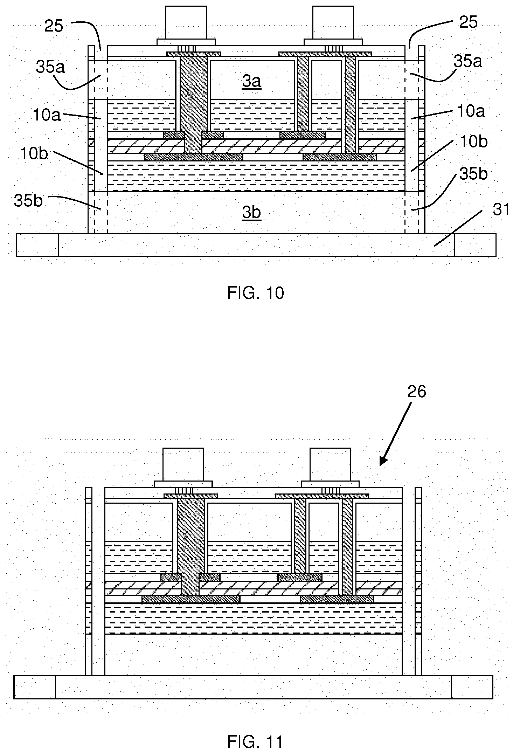

Then the actual singulation of the die stack is performed by etching through the substrates 3a/3b in the area defined by the aligned singulation streets. A first embodiment to bring this into practice is shown in Figures 8 to 11. The wafer stack as shown in Figure 7b may be reversed and attached to a back-grinding tape 30, see Figure 8, with the bumps or pillars 22 embedded in the tape and the lower substrate 3a now oriented upwards. With the wafer stack firmly attached to the backgrinding tape 30, the substrate 3a is thinned by a backgrinding step as known per se in the art, see Figure 9. The thinned wafer stack is then transferred to a dicing tape 31, see Figure 10, and the backgrinding tape 30 is removed. While attached to the dicing tape 31, singulation of the stack into separate die stacks is done by anisotropically etching through the substrates 3a and 3b, thereby removing the material of these substrates that is aligned with the singulation streets 10a/10b/25. The etch process used for etching the semiconductor material is highly anisotropic so that essentially only the semiconductor material is removed from the areas 35a and 35b of the respective semiconductor substrates 3a and 3b which are aligned with the stack of aligned singulation streets. At the same time, the etch process has to be highly anisotropic and/or selective with respect to the materials of the FEOL/BEOL portions 4a/4b, the redistribution layers 5a/5b, the bonding layers 7a/7b and the dielectric layers 14/19, so that no or little of these layers is removed beyond the previously formed singulation streets 10a/10b. In other words, the shape and size of the singulation streets 25/10a/10b dictates the removal of the semiconductor material from narrow areas corresponding to the singulation streets. This means that no lithography mask needs to be applied before removal of the substrate material from the areas 35a/35b. This results in the singulation of the die stacks and formation of the singulated 3D dies 26, as shown in Figure 11. When the substrates 3a/3b are silicon substrates, the etch process for removing the substrate material in the areas 35a/35b aligned with the singulation streets is a plasma silicon etch as known in the art. A preferred plasma etch process applies a C₄F₈/SF₆ based etch chemistry, with alternate Si etching and polymer deposition cycles (so-called Bosch process). The 3D dies 26 can be further handled by a pick and place method for example.

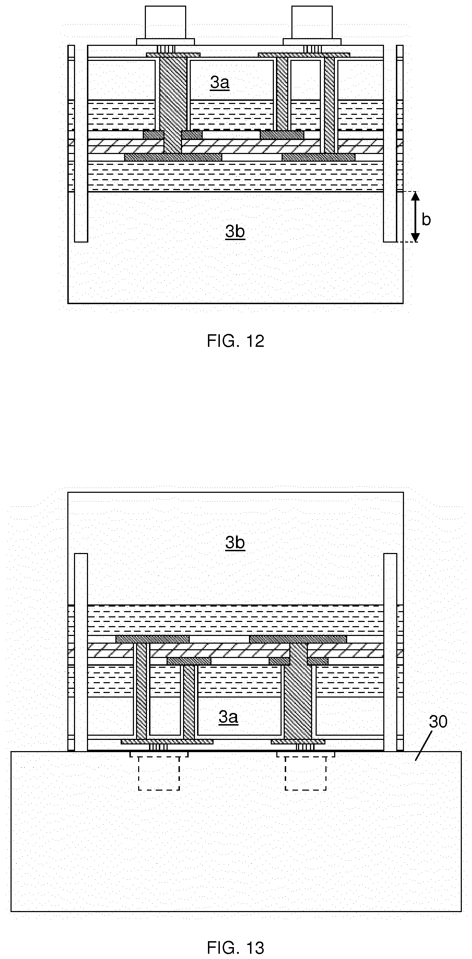

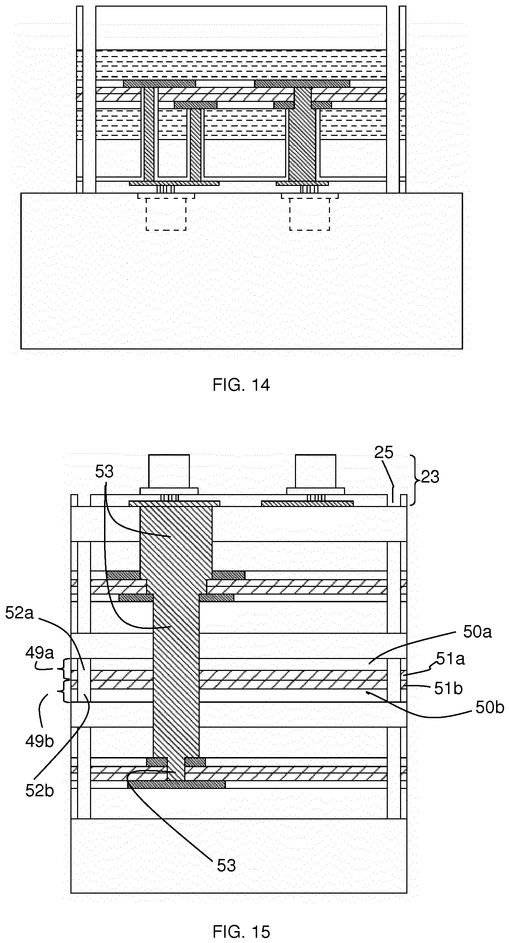

Another embodiment of the method to complete the singulation of the wafer stack following the situation shown in Figure 7b, is illustrated in Figures 12 to 14. According to this embodiment, the substrates 3a/3b are etched on the wafer stack itself, i.e. without first transferring the stack to a backgrinding tape. This is illustrated in Figure 12 : the substrates are anisotropically etched according to the previously formed singulation streets 25/10a/10b, i.e. by a similar etch process as described with respect to Figures 10 and 11, until a given depth b is reached in the bottom substrate 3b. Then, the wafer stack is attached to a backgrinding tape 30 (Figure 13), and the partially etched substrate 3b is thinned until the etched portion is reached, thereby effectuating the singulation into separate 3D dies, see Figure 14. After transferral to a dicing tape (resulting in the same situation as the one shown in Figure 11), the 3D dies 26 can again be used in a pick and place method.

According to an embodiment, the lithography mask 24 (see Figure 7a) used for producing the upper singulation street 25 is not stripped prior to the etching of the substrates in the areas 35a/35b defined by the singulation streets, but only after the dicing is completed by etching through the substrates 3a/3b. The mask 24 is able to give additional protection of the top layer 23 during the etching of the substrates 3a/3b. Keeping the mask 24 on the stack until after singulation is possible in both singulation variants shown in Figures 8-11 and 12-14 respectively. In the first case, stripping the resist is preferably done while the singulated die stacks are still on the dicing tape 31. In the second case, stripping the resist can be done after etching down to depth b in Figure 12 or the resist may be stripped on the singulated die stacks.

According to the invention, the separation of a die stack from the wafer stack may be done by a single etching step performed on the wafer stack, for etching through the substrates 3a/3b in the areas 35a/35b corresponding to the singulation streets. With a single etch step is meant : a process performed in a single etch tool without removing the stack from the tool. This simplification is due to the fact that the intermediate singulation streets 10a/10b on the die-carrying wafers have been produced prior to bonding. It is therefore not necessary to move the stack from one etching tool to another during the singulation procedure. Once the stack is formed, the singulation can therefore be performed quickly and with high throughput.

100% perfect alignment of the singulation streets 10a and 10b is not required, given that a small misalignment will not stand in the way of the anisotropic etching of the semiconductor material 35a/35b aligned with the singulation streets. Also, small differences in the width or other dimensions of the singulation streets are allowed, as long as it is possible to align the singulation streets with respect to each other.

Figure 15 illustrates how the method can be used for singulating a stack of more than two wafers according to the method of the invention. In the embodiment shown, two stacks of two wafers each are bonded together to form a 4 wafer stack. The facing surfaces of the two 2-wafer stacks which are to be bonded are provided with a functional layer 49a/49b, comprising a layer 50a/50b which may for example be a single dielectric layer. The functional layers 49a/49b further comprise a direct bonding layer 51a/51b. For example, layers 50a/50b may be silicon nitride layers acting as passivation layers which form a barrier against Cu-diffusion, with 51a/51b being both silicon oxide layers or polymer layers or one oxide layer and one polymer layer. In another example, layers 50a/50b are silicon oxide layers and 51a/51b are SiCN layers, acting as bonding layers and simultaneously forming a barrier against Cu-diffusion. Intermediate singulation streets 52a/52b are produced in the manner described above, i.e. by removal of the material of the functional layer portions 49a/49b in a narrow area along the circumference of the dies. After that, the two stacks are bonded by bringing the direct bonding layers 51a/51b into mutual contact preferably followed by an anneal step. After completion of TSVs, in this case a set of TSVs 53 with different diameters interconnecting the four dies (the liner is present but not shown in the drawing), and after fabrication of the top layer 23 and production of an upper singulation street 25, the stack of 4 wafers may be diced by a single step of etching the semiconductor substrates of the four wafers, in the same manner as described above for the case of the two wafers.

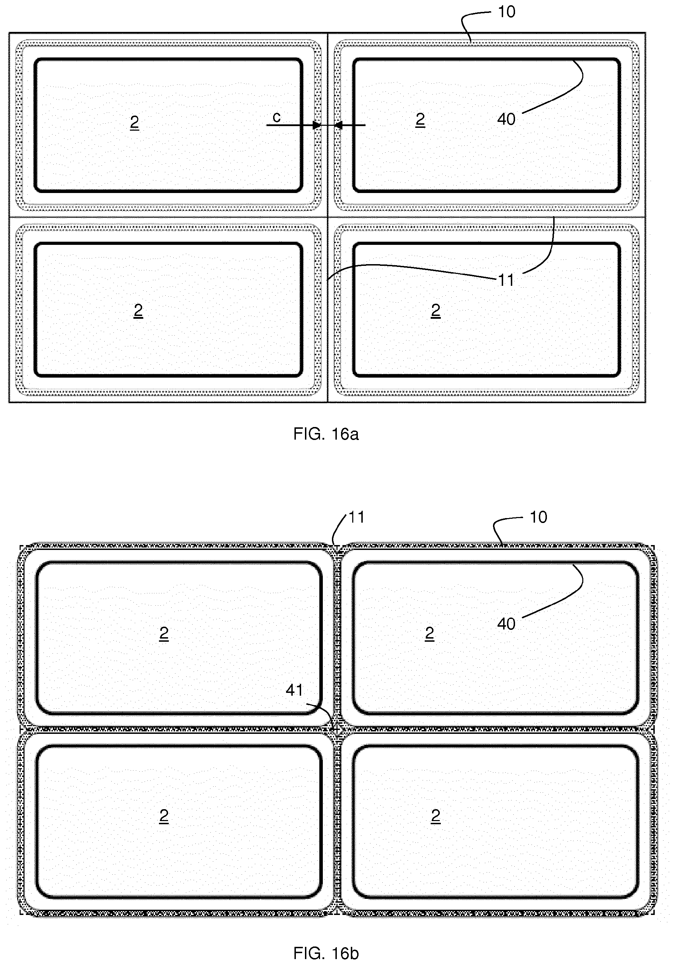

Figure 16a is an image of multiple dies 2 on a wafer, this time showing the position of the singulation streets 10 within the footprints of four adjacent dies 2. The dies are preferably provided with a die seal ring 40 as known in the art. According to a preferred embodiment, the singulation streets are centered around the seal ring 40, i.e. shifted outward over a fixed distance with respect to the seal ring. Through the fact that the width of the singulation streets 10 may be in the order of micrometers, e.g. between 5 and 15 micrometers depending on the thickness of the substrates 3a/3b, an important gain is reached in terms of the loss of wafer surface when using the method of the invention compared to standard dicing techniques, which require a larger area to be reserved for the dicing streets between dies. The usage of the wafer surface may be further optimized by reducing the distance c between neighbouring singulation streets, up to and including the situation where there is not a separate singulation street for each die, but the singulation streets overlap the boundaries 11 between the dies. A preferred embodiment of this type is shown in Figure 16b, where the sides of the singulation streets (except in the corners) overlap the boundaries between two adjacent dies and each side of a singulation street is common to two adjacent dies. In this embodiment, only narrow columns 41 of the wafer stack remain when the singulation is completed. Alternatively, the area corresponding to these columns could be removed during etching of the intermediate singulation streets 10, by appropriately designing the litho mask for this purpose (i.e. by including the column 41 in the pattern of the singulation streets). The rounded corners of the intermediate singulation streets 10 are preferably deliberately designed with a given radius (depending on the surface area within the singulation street), by designing the lithographic mask used to etch the intermediate streets. The rounded corners will minimize stress formation in the singulated die stacks. The fact that it is possible to design these rounded corners is an advantage of the method of the invention, not available when using classic dicing techniques such as blade dicing. Instead of rectangular shaped dies, the dies may have the form of any polygon. It is another advantage of the invention that the shape of the surface areas of the dies is not limited to rectangles or squares. Any polygon shape can be realised, as the shape of the singulation streets can be adapted to the shape of the die area.

As stated above, direct bonding layers may be any of several known types of dielectric layers suitable for this purpose, such as oxide layers or photopatternable polymer glue layers. Bonding layers applied on two bonded surfaces may be the same (e.g. oxide-oxide bonding) or different (e.g. oxide-polymer). Photopatternable polymer glue layers are known as such in the art. When the latter are used in the method of the invention, the following points may differ from the above-described process sequences. Preferably the intermediate singulation streets are first formed in the functional layer before producing the polymer layer, and then separately in the polymer layer, after deposition of this polymer layer. According to the embodiment according to Figures 3-6 but with layers 7a/7b being photopatternable polymer layers (described here with reference to one die 2a but valid also for the opposite die 2b), the intermediate dicing street 10a is first produced in the stack consisting of the FEOL/BEOL portion 4a and the redistribution layer 5a. Then a polymer bonding layer is applied, i.e. also in the intermediate singulation street 10a. Then the polymer may be removed from the intermediate singulation street by lithography only, i.e. illuminating through a mask and developing/stripping the polymer, taking advantage of the photolithographic characteristics of the polymer. Alternatively, the polymer is removed from the intermediate dicing street by litho+dry etching by an etch recipe adapted for etching the polymer, using the same litho-mask as the one used for etching through portions 4a and 5a. The other features of the method of the invention in the case of polymer-based direct bonding are identical to the above-described embodiments wherein oxide-oxide bonding is used.

While the invention has been illustrated and described in detail in the drawings and foregoing description, such illustration and description are to be considered illustrative. Other variations to the disclosed embodiments can be understood and effected by those skilled in the art. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details the embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing and singulating a wafer stack, each wafer of the wafer stack comprising one or more integrated circuit dies (2a,2b), each wafer comprising a semiconductor substrate and a functional layer on at least one side of the substrate, the dies (2a,2b) being defined by delimited portions of the functional layer (1a,1b;49a,49b) and of the substrate (3a,3b), wherein the wafer stack is produced by :
• one or more steps of directly bonding a first wafer to a second wafer, wherein functional layer portions (1a, 49a) of one or more dies of the first wafer are bonded respectively to functional layer portions (1b,49b) of one or more dies of the second wafer, so as to form a wafer stack comprising one or more stacks of bonded dies, and
• after the direct bonding steps, forming a top layer (23) on the wafer stack comprising on top of the stacks of bonded dies, one or more contact structures (22) electrically connected to an underlying stack of bonded dies,
and wherein :
• prior to each direct bonding step, intermediate singulation streets (10a,10b;52a,52b) are produced on the facing surfaces of two wafers that are to be bonded together, by removing the material of the functional layers from the facing surfaces, in areas which circumvent a central portion (2') of a die (2a,2b),
• prior to each direct bonding step, the method comprises the step of aligning the intermediate singulation streets of the facing surfaces of the two wafers to be bonded,
• all of the intermediate singulation streets in the stacks of bonded dies formed in the wafer stack being aligned to each other,
• after fabrication of the top layer (23) of the wafer stack, an upper singulation street (25) is produced in the top layer (23) for each stack of dies formed in the wafer stack, by removing the materials of the top layer from an area of the top layer, the upper singulation street being aligned with the previously produced intermediate singulation streets ,
• after the formation of the upper singulation street (25), the wafer stack is singulated by etching the semiconductor substrates of the wafer stack in the areas corresponding to the aligned intermediate and upper singulation streets (10a,10b,52a,52b,25), thereby obtaining one or more singulated die stacks (26).

2. Method according to claim 1, wherein the intermediate singulation streets (10a,10b;52a,52b) are produced by a lithography and etch process and wherein no metallic materials are present in the areas which are removed in the lithography and etch processes.

3. Method according to claim 1 or 2, wherein the upper singulation street (25) is produced by a lithography and etch process and wherein no metallic materials are present in the area of the top layer that is removed in the lithography and etch process.

4. Method according to claim 3, wherein a lithographic mask (24) is applied on the top layer (23) and wherein the mask is still present on the top layer (23) when the wafer stack is singulated by etching the semiconductor substrates.

5. Method according to any one of claims 1 to 4, wherein the step of singulating the wafer stack is done by a single anisotropic etching step of semiconductor material in the areas (35a,35b) of the semiconductor substrates corresponding to the singulation streets (10a,10b,52a,52b, 25).

6. Method according to any one of the preceding claims, wherein after fabrication of the upper singulation street (25), the wafer stack is reversed and subsequently transferred to a backgrinding tape (30), after which the wafer stack is thinned and then transferred to a dicing tape (31), and wherein the singulated die stacks (26) are obtained by etching all of the semiconductor material in the areas (35a,35b) of the substrates corresponding to the aligned intermediate and upper singulation streets (10a,10b,52a,52b, 25), while the wafer stack is attached to the dicing tape (31).

7. Method according to any one of claims 1 to 5, wherein after fabrication of the upper singulation street (25), the semiconductor material in the areas (35a, 35b) of the semiconductor substrates corresponding to the aligned intermediate and upper singulation streets (10a,10b,52a,52b, 25) is etched and thereby removed completely from every substrate in the stack except the bottom substrate, and wherein said material is removed in the bottom substrate down to a pre-defined depth (b), after which the stack is transferred to a backgrinding tape (30), and the wafer stack is thinned until the one or more singulated die stacks (26) are obtained.

8. Method according to any one of the preceding claims, wherein the dies (2) have a polygon-shaped surface area, and wherein the sides of the intermediate and upper singulation streets are parallel to the boundary (11) of the surface area, except in the corners where the singulation streets are rounded.

9. Method according to any one of claims 1 to 7, wherein the dies (2) form an array of adjacent polygon-shaped areas on the wafers, and wherein at least part of the sides of the intermediate and upper singulation streets overlap the boundaries (11) between two adjacent dies.

10. Method according to any one of the preceding claims, wherein the dies (2a,2b) that are to be bonded comprise a die seal ring (40) and wherein the intermediate singulation streets (10a,10b,52a,52b) are outward of and concentric with the die seal ring.

11. Method according to any one of the preceding claims, wherein the width of the intermediate and upper singulation streets is between 5 and 15 micrometers.

12. Method according to any one of the preceding claims, wherein the contact structures (22) comprise contact bumps or pillars.

13. Method according to any one of the preceding claims, comprising the formation of one or more interconnect structures (15,16,17) fully or partially through the stacks of bonded dies so as to electrically connect one or more of the functional layer portions to the top layer (23).

14. Method according to any one of the preceding claims, in the case of a plurality of direct bonding steps, wherein the first of the direct bonding steps is between two single wafers, to thereby form a first stack, and wherein each subsequent direct bonding step is between a single wafer and a wafer of the previously produced stack.

15. Method according to any one of claims 1 to 13, in the case of a plurality of direct bonding steps, wherein at least one of the direct bonding steps is between a wafer of a first stack and a wafer of a second stack, the first and second stacks having been produced by preceding direct bonding steps.

## Patentansprüche

1. Verfahren zum Herstellen und Vereinzeln eines Waferstapels, wobei jeder Wafer des Waferstapels einen oder mehrere integrierte Schaltungschips (2a, 2b) umfasst, wobei jeder Wafer ein Halbleitersubstrat und eine funktionelle Schicht auf mindestens einer Seite des Substrats umfasst, wobei die Chips (2a, 2b) durch abgegrenzte Abschnitte der funktionellen Schicht (1a, 1b; 49a, 49b) und des Substrats (3a, 3b) definiert sind, wobei der Waferstapel hergestellt wird durch:
- einen oder mehrere Schritte des direkten Bondens eines ersten Wafers an einen zweiten Wafer, wobei Abschnitte der funktionellen Schicht (1a, 49a) eines oder mehrerer Chips des ersten Wafers jeweils an Abschnitte der funktionellen Schicht (1b, 49b) eines oder mehrerer Chips des zweiten Wafers gebondet werden, um einen Waferstapel zu bilden, der einen oder mehrere Stapel gebondeter Chips umfasst, und
- nach den Schritten des direkten Bondens, Bilden einer Deckschicht (23) auf dem Waferstapel, die an der Deckseite des Stapels gebondeter Chips eine oder mehrere Kontaktstrukturen (22) umfasst, die elektrisch mit einem darunterliegenden Stapel gebondeter Chips verbunden sind, und wobei:
- vor jedem Schritt des direkten Bondens Zwischenvereinzelungsbahnen (10a, 10b; 52a, 52b) an den einander zugewandten Flächen von zwei Wafern, die aneinander gebondet werden sollen, hergestellt werden, indem das Material der funktionellen Schichten von den einander zugewandten Flächen in Bereichen, die einen zentralen Abschnitt (2') eines Chips (2a, 2b) umschreiben, entfernt wird,
- das Verfahren vor jedem Schritt des direkten Bondens den Schritt des Ausrichtens der Zwischenvereinzelungsbahnen der einander zugewandten Flächen der zwei Wafer, die gebondet werden sollen, umfasst,
- wobei alle der Zwischenvereinzelungsbahnen in dem Stapel gebondeter Chips, die im Waferstapel gebildet sind, zueinander ausgerichtet werden,
- nach dem Anfertigen der Deckschicht (23) des Waferstapels für jeden Chipstapel, der im Waferstapel gebildet ist, eine obere Vereinzelungsbahn (25) in der Deckschicht (23) hergestellt wird, indem die Materialien der Deckschicht von einem Bereich der Deckschicht entfernt werden, wobei die obere Vereinzelungsbahn zu den zuvor hergestellten Zwischenvereinzelungsbahnen ausgerichtet wird,
- nach dem Bilden der oberen Vereinzelungsbahn (25) der Waferstapel vereinzelt wird, indem die Halbleitersubstrate des Waferstapels in den Bereichen, die den ausgerichteten Zwischen- und oberen Vereinzelungsbahnen (10a, 10b, 52a, 52b, 25) entsprechen, geätzt werden, wodurch ein oder mehrere vereinzelte Chipstapel (26) erhalten werden.

2. Verfahren nach Anspruch 1, wobei die Zwischenvereinzelungsbahnen (10a, 10b; 52a, 52b) über einen Lithographie- und Ätzprozess hergestellt werden, und wobei in den Bereichen, die in den Lithographie- und Ätzprozessen entfernt werden, keine metallischen Materialien vorliegen.

3. Verfahren nach Anspruch 1 oder 2, wobei die obere Vereinzelungsbahn (25) über einen Lithographie- und Ätzprozess hergestellt wird, und wobei in dem Bereich der Deckschicht, der in dem Lithographie- und Ätzprozess entfernt wird, keine metallischen Materialien vorliegen.

4. Verfahren nach Anspruch 3, wobei eine Lithographiemaske (24) auf die Deckschicht (23) aufgebracht wird, und wobei die Maske immer noch auf der Deckschicht (23) vorliegt, wenn der Waferstapel durch Ätzen der Halbleitersubstrate vereinzelt wird.

5. Verfahren nach einem der Ansprüche 1 bis 4, wobei der Schritt des Vereinzelns des Waferstapels über einen einzelnen Schritt des anisotropen Ätzens von Halbleitermaterial in den Bereichen (35a, 35b) der Halbleitersubstrate erfolgt, die den Vereinzelungsbahnen (10a, 10b, 52a, 52b, 25) entsprechen.

6. Verfahren nach einem der vorstehenden Ansprüche, wobei nach dem Anfertigen der oberen Vereinzelungsbahn (25) der Waferstapel umgedreht und anschließend auf ein Backgrinding-Band (30) transferiert wird, wonach der Waferstapel ausgedünnt und dann auf ein Dicing-Band (31) transferiert wird, und wobei die vereinzelten Chipstapel (26) erhalten werden, indem das gesamte Halbleitermaterial in den Bereichen (35a, 35b) der Substrate, die den ausgerichteten Zwischen- und oberen Vereinzelungsbahnen (10a, 10b, 52a, 52b, 25) entsprechen, geätzt wird, während der Waferstapel am Dicing-Band (31) befestigt ist.

7. Verfahren nach einem der Ansprüche 1 bis 5, wobei nach dem Anfertigen der oberen Vereinzelungsbahn (25) das Halbleitermaterial in den Bereichen (35a, 35b) der Halbleitersubstrate, die den ausgerichteten Zwischen- und oberen Vereinzelungsbahnen (10a, 10b, 52a, 52b, 25) entsprechen, geätzt und dadurch vollständig von jedem Substrat in dem Stapel, mit Ausnahme des untersten Substrats, entfernt wird, und wobei das Material im untersten Substrat bis hinab zu einer vordefinierten Tiefe (b) entfernt wird, wonach der Stapel auf ein Backgrinding-Band (30) transferiert wird, und der Waferstapel ausgedünnt wird, bis der eine oder die mehreren vereinzelten Chipstapel (26) erhalten werden.

8. Verfahren nach einem der vorstehenden Ansprüche, wobei die Chips (2) einen polygonförmigen Oberflächenbereich aufweisen, und wobei die Seiten der Zwischen-und oberen Vereinzelungsbahnen zur Grenze (11) des Oberflächenbereichs parallel sind, mit Ausnahme in den Ecken, in denen die Vereinzelungsbahnen gerundet sind.

9. Verfahren nach einem der Ansprüche 1 bis 7, wobei die Chips (2) eine Anordnung von benachbarten polygonförmigen Bereichen auf den Wafern bilden, und wobei mindestens ein Teil der Seiten der Zwischen- und oberen Vereinzelungsbahnen mit den Grenzen (11) zwischen zwei benachbarten Chips überlappen.

10. Verfahren nach einem der vorstehenden Ansprüche, wobei die Chips (2a, 2b), die gebondet werden sollen, einen Chipdichtungsring (40) umfassen, und wobei die Zwischenvereinzelungsbahnen (10a, 10b, 52a, 52b) außerhalb des Chipdichtungsrings liegen und konzentrisch zu demselben sind.

11. Verfahren nach einem der vorstehenden Ansprüche, wobei die Breite der Zwischen- und oberen Vereinzelungsbahnen zwischen 5 und 15 Mikrometer beträgt.

12. Verfahren nach einem der vorstehenden Ansprüche, wobei die Kontaktstrukturen (22) Kontakthöcker oder -säulen umfassen.

13. Verfahren nach einem der vorstehenden Ansprüche, das das Bilden von einer oder mehreren Verbindungsstrukturen (15, 16, 17) ganz oder teilweise durch die Stapel gebondeter Chips hindurch umfasst, um einen oder mehrere der Abschnitte der funktionellen Schicht elektrisch mit der Deckschicht (23) zu verbinden.

14. Verfahren nach einem der vorstehenden Ansprüche im Falle einer Vielzahl von Schritten des direkten Bondens, wobei der erste der Schritte des direkten Bondens zwischen zwei einzelnen Wafern erfolgt, um dadurch einen ersten Stapel zu bilden, und wobei jeder anschließende Schritt des direkten Bondens zwischen einem einzelnen Wafer und einem Wafer des zuvor hergestellten Stapels erfolgt.

15. Verfahren nach einem der Ansprüche 1 bis 13 im Falle einer Vielzahl von Schritten des direkten Bondens, wobei mindestens einer der Schritte des direkten Bondens zwischen einem Wafer eines ersten Stapels und einem Wafer eines zweiten Stapels erfolgt, wobei der erste und zweite Stapel über vorhergehende Schritte des direkten Bondens hergestellt wurden.

## Revendications

1. Procédé permettant de produire et d'individualiser une pile de tranches, chaque tranche de la pile de tranches comprenant un ou plusieurs dés de circuit intégré (2a, 2b), chaque tranche comprenant un substrat semi-conducteur et une couche fonctionnelle sur au moins un côté du substrat, les dés (2a, 2b) étant définis par des portions délimitées de la couche fonctionnelle (1a, 1b ; 49a, 49b) et du substrat (3a, 3b), dans lequel la pile de tranches est produite par :
• une ou plusieurs étapes consistant à lier directement une première tranche à une seconde tranche, dans lequel des portions de couche fonctionnelle (1a, 49a) d'un ou plusieurs dés de la première tranche sont liées respectivement à des portions de couche fonctionnelle (1b, 49b) d'un ou plusieurs dés de la seconde tranche, de manière à former une pile de tranches comprenant une ou plusieurs piles de dés liés, et
• après les étapes de liaison directe, la formation d'une couche supérieure (23) sur la pile de tranches comprenant par-dessus les piles de dés liés une ou plusieurs structures de contact (22) connectées électriquement à une pile sous-jacente de dés liés, et dans lequel :
• préalablement à chaque étape de liaison directe, des voies d'individualisation intermédiaires (10a, 10b ; 52a, 52b) sont produites sur les surfaces se faisant face de deux tranches qui doivent être liées ensemble, en enlevant le matériau des couches fonctionnelles des surfaces se faisant face, dans des zones qui contournent une portion centrale (2') d'un dé (2a, 2b),
• préalablement à chaque étape de liaison directe, le procédé comprend l'étape consistant à aligner les voies d'individualisation intermédiaires des surfaces se faisant face des deux couches à lier,
• la totalité des voies d'individualisation intermédiaires dans les piles de dés liés formées dans la pile de tranches alignées les unes avec les autres,
• après la fabrication de la couche supérieure (23) de la pile de tranches, une voie d'individualisation supérieure (25) est produite dans la couche supérieure (23) pour chaque pile de dés formée dans la pile de tranches, en enlevant les matériaux de la couche supérieure d'une zone de la couche supérieure, la voie d'individualisation supérieure étant alignée avec les voies d'individualisation intermédiaires produites précédemment,
• après la formation de la voie d'individualisation supérieure (25), la pile de tranches est individualisée en gravant les substrats semi-conducteurs de la pile de tranches dans les zones correspondant aux voies d'individualisation intermédiaires et supérieures alignées (10a, 10b, 52a, 52b, 25), obtenant ainsi une ou plusieurs piles de dés individualisées (26).

2. Procédé selon la revendication 1, dans lequel les voies d'individualisation intermédiaires (10a, 10b ; 52a, 52b) sont produites par un processus de lithographie et de gravure et dans lequel aucun matériau métallique n'est présent dans les zones qui sont enlevées lors des processus de lithographie et de gravure.

3. Procédé selon la revendication 1 ou 2, dans lequel la voie d'individualisation supérieure (25) est produite par un processus de lithographie et de gravure et dans lequel aucun matériau métallique n'est présent dans la zone de la couche supérieure qui est enlevée lors du processus de lithographie et de gravure.

4. Procédé selon la revendication 3, dans lequel un masque lithographique (24) est appliqué sur la couche supérieure (23) et dans lequel le masque est encore présent sur la couche supérieure (23) lorsque la pile de tranches est individualisée en gravant les substrats semi-conducteurs.

5. Procédé selon l'une quelconque des revendications 1 à 4, dans lequel l'étape consistant à individualiser la pile de tranches est menée à bien par une étape de gravure anisotrope unique de matériau semi-conducteur dans les zones (35a, 35b) des substrats semi-conducteurs correspondant aux voies d'individualisation (10a, 10b, 52a, 52b, 25).

6. Procédé selon l'une quelconque des revendications précédentes, dans lequel après la fabrication de la voie d'individualisation supérieure (25), la pile de tranches est mise à l'envers et transférée ultérieurement à un ruban de rectification (30), après quoi la pile de tranches est amincie et ensuite transférée à un ruban de découpage en dés (31), et dans lequel les piles de dés individualisées (26) sont obtenues en gravant la totalité du matériau semi-conducteur dans les zones (35a, 35b) des substrats correspondant aux voies d'individualisation intermédiaires et supérieures alignées (10a, 10b, 52a, 52b, 25), tandis que la pile de tranches est fixée au ruban de découpage en dés (31).

7. Procédé selon l'une quelconque des revendications 1 à 5, dans lequel après la fabrication de la voie d'individualisation supérieure (25), le matériau semi-conducteur dans les zones (35a, 35b) des substrats semi-conducteurs correspondant aux voies d'individualisation intermédiaires et supérieure alignées (10a, 10b, 52a, 52b, 25) est gravé et ainsi enlevé complètement de chaque substrat dans la pile à l'exception du substrat du fond, et dans lequel ledit matériau est enlevé dans le substrat du fond jusqu'à une profondeur prédéfinie (b), après quoi la pile est transférée à un ruban de rectification (30), et la pile de tranches est amincie jusqu'à ce que les une ou plusieurs piles de dés individualisées (26) soient obtenues.

8. Procédé selon l'une quelconque des revendications précédentes, dans lequel les dés (2) présentent une aire en forme de polygone, et dans lequel les côtés des voies d'individualisation intermédiaires et supérieure sont parallèles à la limite (11) de la superficie, à l'exception des coins où les voies d'individualisation sont arrondies.

9. Procédé selon l'une quelconque des revendications 1 à 7, dans lequel les dés (2) forment un réseau de zones en forme de polygone adjacentes sur les tranches, et dans lequel au moins une partie des côtés des voies d'individualisation intermédiaires et supérieure chevauchent les limites (11) entre deux dés adjacents.

10. Procédé selon l'une quelconque des revendications précédentes, dans lequel les dés (2a, 2b) qui doivent être liés comprennent une bague d'étanchéité de dé (40) et dans lequel les voies d'individualisation intermédiaires (10a, 10b, 52a, 52b) sont à l'extérieur de la bague d'étanchéité de dé et concentriques avec celle-ci.

11. Procédé selon l'une quelconque des revendications précédentes, dans lequel la largeur des voies d'individualisation intermédiaires et supérieure se situe entre 5 et 15 micromètres.

12. Procédé selon l'une quelconque des revendications précédentes, dans lequel les structures de contact (22) comprennent des bosses ou piliers de contact.

13. Procédé selon l'une quelconque des revendications précédentes, comprenant la formation d'une ou plusieurs structures d'interconnexion (15, 16, 17) en totalité ou en partie à travers les piles de dés liés de manière à connecter électriquement une ou plusieurs des portions de couche fonctionnelle à la couche supérieure (23).

14. Procédé selon l'une quelconque des revendications précédentes, dans le cas d'une pluralité d'étapes de liaison directe, dans lequel la première des étapes de liaison directe se situe entre deux tranches individuelles, pour ainsi former une première pile, et dans lequel chaque étape de liaison directe ultérieure se situe entre une tranche individuelle et une tranche de la pile produite précédemment.

15. Procédé selon l'une quelconque des revendications 1 à 13, dans le cas d'une pluralité d'étapes de liaison directe, dans lequel au moins l'une des étapes de liaison directe se situe entre une tranche d'une première pile et une tranche d'une seconde pile, les première et seconde piles ayant été produites par des étapes de liaison directe précédentes.
